## Europäisches Patentamt

## European Patent Office

## Office européen des brevets

(19)

(11) Veröffentlichungsnummer: **0 048 291 B1**

(12) **EUROPÄISCHE PATENTSCHRIFT**

(45) Veröffentlichungstag der Patentschrift:
03.07.85

(21) Anmeldenummer: 80105618.5

(22) Anmeldetag: 19.09.80

(51) Int. Cl.⁴: **H 01 L 21/00**, G 03 F 1/00, H 01 L 29/06, H 01 L 23/52, H 01 L 29/40

(54) Struktur mit einem eine durchgehende Öffnung aufweisenden Siliciumkörper und Verfahren zu ihrer Herstellung.

(43) Veröffentlichungstag der Anmeldung:
31.03.82 Patentblatt 82/13

(45) Bekanntmachung des Hinweises auf die Patenterteilung:
03.07.85 Patentblatt 85/27

(84) Benannte Vertragsstaaten:
DE FR GB

(56) Entgegenhaltungen:
EP - A - 0 001 038
EP - A - 0 019 779
FR - A - 2 067 024
FR - A - 2 321 367
GB - A - 1 235 077
US - A - 4 021 276

IBM TECHNICAL DISCLOSURE BULLETIN, Band 19, September 1976, New York, USA S. MAGDO: "Pyramid shaped electrical feedthrough in siliconwafers", Seiten 1232-1233
IBM TECHNICAL DISCLOSURE BULLETIN Band 22, Mai 1980 New York, USA A.P. HO und C.T. HORNG: "Selfaligned process for forming metalsilicide and polysilicon composite base contact", Seiten 5336-5338
INTERNATIONAL ELECTRON DEVICES MEETING, Technical digest, Dezember 1975, Washington, IEEE, New York, US E. BASSOUS et al. "High-transmission X-ray masks for lithographic applications", Seiten 17-19

(56) Entgegenhaltungen: (Fortsetzung)
IEEE TRASNACTIONS ON ELECTRON DEVICES, vol. ED-25, Oktober 1978 New York, USA E. BASSOUS: "Fabrication of novel three-dimensional microstructures by the anisotropic etching of (100) and (110) silicon".
Seiten 1178-1185
IBM TECHNICAL DISCLOSURE BULLETIN, Band 19, Februar 1977 New York, US P.L. GARBARINO et al. "Contact barrier metallurgy for MOSFET gate", Seite 3382
RÖMPPS Chemie-Lexikon, S. 3216

(73) Patentinhaber: IBM DEUTSCHLAND GMBH, Pascalstrasse 100, D-7000 Stuttgart 80 (DE)

(84) Benannte Vertragsstaaten: DE

(73) Patentinhaber: International Business Machines Corporation, Old Orchard Road, Armonk, N.Y. 10504 (US)

(84) Benannte Vertragsstaaten: FR GB

(72) Erfinder: Greschner, Johann, Dr., Zollernstrasse 14, D-7401 Pliezhausen 2 (DE)
Erfinder: Kraus, Georg, Im Heinental 70, D-7277 Wildberg 4 (DE)
Erfinder: Schmid, Gerhard, Dr., Lindachweg 18, D-7021 Setten/Filder (DE)

(74) Vertreter: Oechssler, Dietrich, Dr.rer.nat. Dipl.-Chem., Schönaicher Strasse 220, D-7030 Böblingen (DE)

## Beschreibung

Die Erfindung betrifft eine Struktur, welche einen flachen einkristallinen Siliciumkörper mit mindestens einer durchgehenden Öffnung und eine den Siliciumkörper mindestens einseitig kontaktierende und bedeckende dünne Schicht enthält und ein Verfahren zur Herstellung einer solchen Struktur.

Eine Struktur der genannten Art lässt sich beispielsweise beim selektiven Bearbeiten von Werkstücken mit energiereicher Strahlung verwenden. Unter energiereicher Strahlung werden in diesem Zusammenhang insbesondere Ionenstrahlen, Elektronenstrahlen und Röntgenstrahlen verstanden. Zu den Bearbeitungsverfahren, bei welchen die genannten Strahlen angewandt werden, gehören beispielsweise die Ionenimplantation, das Ionenätzen und die Ionenstrahl-, die Elektronenstrahl- und die Röntgenstrahllithographie. Diese Verfahren sind beispielsweise in der Halbleitertechnik interessant und werden es immer mehr mit dem zunehmenden Trend zu Mikrominiaturisierung und zur dichteren Packung der Bauelemente, der in diesem Bereich der Technik zu beobachten ist. Im folgenden wird im wesentlichen nur auf die Verwendung der genannten Struktur bei der Elektronenstrahl- und der Röntgenstrahllithographie eingegangen. Diese Beschränkung ist zweckmässig, da einerseits sich die genannte Struktur bei der Elektronenstrahl- und der Röntgenstrahllithographie besonders vorteilhaft einsetzen lässt und andererseits die dabei zu beachtenden Faktoren und die zu überwindenden Schwierigkeiten weitgehend für die anderen Einsatzmöglichkeiten der genannten Struktur genauso typisch sind. Diese Beschränkung auf die Elektronenstrahl- und Röntgenstrahllithographie bedeutet jedoch nicht, dass die genannte Struktur nicht ebenso für die anderen genannten Zwecke eingesetzt werden kann.

Zur Herstellung von Strukturen mit Elementen, deren Abmessungen im μm-Bereich und darunter liegen, auf «photo»-lithographischem Weg, ist ultraviolettes Licht zur Bestrahlung nicht mehr geeignet, da sich mit ihm nicht die notwendige Auflösung erzielen lässt. In solchen Fällen wird der strahlungsempfindliche Lack bevorzugt mit Elektronen- oder Röntgenstrahlen bestrahlt, wobei die letzteren bezüglich der Auflösung sogar noch vorteilhafter als die Elektronenstrahlen sind.

Bei den in der Elektronenstrahllithographie eingesetzten Elektronenstrahl-Belichtungsgeräten unterscheidet man zwischen Elektronenstrahl-Abtastsystemen und Elektronenstrahl-Replikationssystemen. Bei den Elektronenstrahl-Abtastsystemen überstreicht ein Elektronenstrahl jeden Punkt einer selektiv zu bestrahlenden Fläche, beispielsweise eine strahlungsempfindliche Lackschicht auf einem Werkstück, wobei an den Stellen, an denen keine Bestrahlung stattfinden soll, über eine Computersteuerung der Elektronenstrahl abgeschaltet oder ausgeblendet wird, und generiert dabei das gewünschte Bestrahlungsmuster. Bei den Elektronenstrahl-Replikationssystemen wird die selektiv zu bestrahlende Fläche durch eine Maske hindurch bestrahlt, welche ein dem zu erzeugenden Muster entsprechendes Muster von durchgehenden Öffnungen aufweist.

Ein Elektronenstrahl-Abtastsystem ist in dem Artikel «Variable Spot Shaping for Electron Beam Lithography» von H.C. Pfeiffer im Journal of Vacuum Science Technology, 15(3), Mai/Juni 1978, Seite 887 ff. beschrieben. Bei diesem System wird eine (bzw. zwei) quadratische Aperturblende, welche mit einem aus einer Elektronenquelle austretenden Elektronenstrahl bestrahlt wird, verkleinert auf das zu belichtende Substrat abgebildet. Das heisst, auf das Substrat trifft ein Elektronenstrahl mit quadratischem Querschnitt auf. In dem von Pfeiffer beschriebenen System hat die Aperturblende eine Grösse von $500 \times 500 \ \mu m^2$. Das quadratische Loch wird durch «Elektroerosion» aus einem Tantalblech herausgearbeitet. Die Qualität des Lochs ist nicht sehr gut, was in diesem Zusammenhang bedeutet, dass die Lochkanten rauh sind, dass die Lochecken stark abgerundet sind und dass die Kanten des Lochs nicht exakt senkrecht aufeinander stehen. Zwar wirkt sich die schlechte Qualität dann nicht so stark aus, wenn – wie bei den einfacheren Systemen – die Aperturblende generell 200fach verkleinert auf dem Substrat abgebildet wird, jedoch ist eine Qualitätsverbesserung dieser Aperturblenden dringend notwendig, wenn sie in Systeme eingesetzt werden, welche mit variablen Strahldurchmessern arbeiten. Bei diesen Systemen kann der Strahldurchmesser an die Grösse des gerade zu bestrahlenden Musterelements angepasst werden, wodurch es möglich ist, eine Fläche wesentlich schneller zu bestrahlen, als wenn der Strahl nur einen konstanten, auf die Dimensionen der kleinsten vorkommenden Musterelemente abgestimmten Durchmesser hat. Der Faktor, um den verkleinert die Aperturblende auf das zu belichtende Substrat abgebildet wird, ist bei den mit variablem Elektronenstrahl-Durchmesser arbeitenden Systemen wesentlich kleiner als bei den Systemen, welche mit konstantem Strahldurchmesser arbeiten, und je weniger die Aperturblende bei der Abbildung verkleinert wird, desto gravierender wirkt sich ihre schlechte Qualität aus.

Überstreicht ein Elektronenstrahl eine beispielsweise $10 \times 10 \ mm^2$ grosse Fläche, so bleibt bei Konstanthaltung der übrigen Bedingungen der Strahldurchmesser nicht konstant, d. h. die Fokussierung des Strahls verändert sich. Eine solche Veränderung der Fokussierung kann durch eine Steuerung des Linsenstroms während des Überstreichens kompensiert werden (dynamische Fokussierung). Um die Abweichung der Fokussierung vom Sollwert in den einzelnen Bereichen der zu bestrahlenden Fläche zu messen und um die lokal notwendige Veränderung des Linsenstroms festzulegen, werden sogenannte Fokussierungsgitter verwendet. Die bisher verwendeten Fokussierungsgitter bestehen aus zwei Scharen von Metalldrähten, welche möglichst othogonal zueinander in Form eines Kreuzgitters, welches bis zu ca. $15 \times 15 \ mm^2$ gross ist, angeordnet sind. Die Fokussierung mittels dieses Fokussierungsgitters wird in der Weise ermittelt, dass das Fokussierungsgitter an die Stelle der zu bestrahlenden Fläche plaziert wird und dass dann im Bereich eines Kreuzungspunktes zweier Drähte der Elektronenstrahl zunächst auf den einen Draht gerichtet und dann langsam senkrecht zum Draht von diesem weggeführt wird. Dabei wird die durch das Gitter hindurchgehende Strahlintensität Punkt für Punkt registriert. Dasselbe wird am anderen Draht wiederholt, und aus den gemessenen Intensitätswerten wird die Fokussierung am Kreuzungspunkt ermittelt. Die bisher benutzte Anordnung hat erhebliche Nachteile. Sie bestehen insbesondere darin, dass die Drähte nicht exakt glatt sind, dass die Drähte nicht exakt senkrecht zueinander ausgerichtet sind, dass die sich kreuzenden Drähte nicht in derselben Ebene liegen, vielmehr in der Strahlrichtung einen Mittelpunktsabstand von 25 µm voneinander haben und dass die Drähte bei dem oben beschriebenen Ermitteln der Fokussierung wegen der lokal sehr hohen thermischen Belastung, welcher sie dabei ausgesetzt sind, ausweichen, d.h. ihre Lage verändern.

Die Röntgenstrahllithographie für die Herstellung integrierter Halbleiterschaltungen wurde anfangs der 70er Jahre zum ersten Mal vorgeschlagen. Ihr Haupteinsatz wird bei der Herstellung von Submikron-Strukturen liegen. Ein wesentlicher Nachteil bei Verwendung konventioneller Röntgenstrahlquellen waren bisher die unwirtschaftlich langen Bestrahlungszeiten. Hier ist in jüngster Zeit eine Wende eingetreten, so dass jetzt genügend intensive Quellen zur Verfügung stehen. Fast noch wichtiger für die Röntgenstrahllithographie ist es, Dünnfilmmasken mit möglichst hohem Kontrast (Definition siehe weiter unten) bei gleichzeitig guter mechanischer Stabilität zur Verfügung zu haben.

Masken für die Röntgenstrahllithographie und ihre Herstellung sind beispielsweise beschrieben in dem Artikel von H.I. Smith u.a. «Fabrication procedure for silicon membrane X-ray lithography masks» in einer Veröffentlichung des Massachusetts Institute of Technology, Lincoln Laboratory, Technical Note 1973–38 vom 20. September 1973 und in dem Vortrag mit dem Titel «High transmission X-ray masks for lithographic applications» von E. Bassous u.a., welcher auf dem International Electron Device Meeting in Washington im Dezember 1975 gehalten worden ist. Die in diesen Artikeln beschriebenen Röntgenstrahlmasken bestehen alle aus einer strukturierten Metallschicht, welche die Röntgenstrahlen absorbieren soll, und welche sich auf einer möglichst dünnen Trägermembran, welche z.B. aus $P^+$-Silicium, Polyimid oder aus einer Siliciumdioxid- und einer Siliciumnitridschicht besteht. Bei der Herstellung der bekannten Masken treten insbesondere bei der Strukturierung der Metallschicht Schwierigkeiten auf. Für die Strukturierung der Metallschicht sind zwei Möglichkeiten bekannt:

1. Die Strukturierung mittels des Elektroplattierens. Dazu ist eine metallische Grundschicht notwendig, die sich auf der gesamten Trägermembran befindet und dadurch den Kontrast verschlechtert. Darüber hinaus handelt es sich beim Elektroplattieren um ein nasschemisches Verfahren. Die damit verbundenen Nachteile müssen in Kauf genommen werden.

2. Strukturieren mittels des Ionenätzens. Dabei handelt es sich um ein Trockenätzen mit Argonionen, wobei die Materialabtragung ausschliesslich aufgrund der kinetischen Energie der auf das Metall auftreffenden Ionen erfolgt. Dieses Verfahren hat erhebliche Nachteile, wenn man Strukturen mit schmalen und gleichzeitig tiefen Gräben ätzen will, da der Photolack, welcher die nicht zu ätzenden Bereiche der Metallschicht abdeckt, praktisch gleich schnell wie das Metall entfernt wird. Macht man, um dieser Schwierigkeit zu begegnen, die Photolackschicht sehr dick, d.h. grösser als 1 µm, so kann man auch dann, wenn das Muster in der Photolackschicht mittels Elektronenstrahlen erzeugt wird, wegen der Streuung der Elektronen keine Musterelemente mit Dimensionen im Submikronbereich erzeugen. Es kommt hinzu, dass man mit dem Ionenätzen zwar durchaus senkrechte Gräben ätzen kann, jedoch schlägt sich das abgeätzte Material auf den Grabenwänden und auf den Wänden der Photolackmaske ab. Diese Ablagerung hat zur Folge, dass nach dem Entfernen der Photolackmaske eine Metallmaske erhalten wird, welche einen störenden «Saum» aufweist, welcher die Musterelemente einrahmt und aus der Maskenebene herausragt. Es ist zwar möglich, diesen «Saum» weitgehend zu vermeiden, indem die Metallschicht während des Ionenätzens gegenüber dem Ionenstrahl gekippt und gleichzeitig rotiert wird. Die Folge dieser Massnahme ist jedoch, dass das erreichbare Verhältnis von Grabentiefe zu Grabenbreite sich noch weiter verkleinert.

Es ist die Aufgabe der Erfindung, eine Struktur, welche insbesondere als Maske beim Arbeiten mit energiereicher Strahlung bzw. als Blende oder Fokussierungsgitter für eine solche Strahlung Verwendung findet und durch eine gute mechanische und thermische Stabilität, Lochmuster mit exakt definierten Abmessungen und einen hohen Kontrast ausgezeichnet sind, und ein Verfahren, um eine solche Struktur unter Einhaltung sehr kleiner Fertigungstoleranzen in einer fabrikmässigen Fertigung herzustellen, anzugeben.

Diese Aufgabe wird mit einer Struktur der eingangs genannten Art mit dem Merkmal des kennzeichnenden Teils des Anspruchs 1 und mit einem Verfahren der eingangs genannten Art mit den Merkmalen des kennzeichnenden Teils des Anspruchs 9 gelöst.

Der Kontrast ist – unabhängig von der Strahlenart – definiert als Verhältnis der Intensität der Strahlung nach dem Durchgang durch die durchgehende Öffnung und ggf. durch eine für die Strahlung durchlässige Maskenunterlage zu der Intensität der Strahlung nach dem Durchgang durch das mit Metallsilizid bedeckte Silicium in der Umgebung der durchgehenden Öffnungen und ggf. durch die Maskenunterlage.

In der erfindungsgemässen Struktur sind die Vorteile von Schwermetallen als Maskenmaterial hinsichtlich der geringen Durchlässigkeit für energiereiche Strahlung und von Silicium hinsichtlich seiner guten mechanischen und thermischen Stabilität und hinsichtlich der günstigen Eigenschaften bei seiner Bearbeitung vereinigt. Es kommt hinzu, dass das Metallsilizid mit dem Silicium über chemische Bindungen verbunden ist, so dass sich die Metallsilizidschicht auch dann, wenn die Struktur lokal oder insgesamt hoch erhitzt wird, vom Siliciumkörper nicht löst. Bei einer vorgegebenen Energie der Strahlung kann, wenn eine bestimmte Absorption der Strahlung gefordert wird, die Metallsilizidschicht umso dünner gemacht werden, je höher die Ordnungszahl der metallischen Komponente des Silizids ist und je höher die Dichte des Silizids ist.

Eine vorteilhafte Ausführungsform der erfindungsgemässen Struktur ist so ausgebildet, dass der Siliciumkörper, welcher aus einem einkristallinen Siliciumplättchen mit (100)-Orientierung besteht, mindestens eine durchgehende Öffnung aufweist, welche parallel zur Plättchenoberfläche einen quadratischen Querschnitt hat, und deren Wände mit der Plättchenoberfläche einen Winkel von 54,7° bilden und dass die Metallsilizidschicht die untere und die obere Oberfläche des Siliciumplättchens und die Wände der Öffnung bzw. der Öffnungen bedeckt. Weist die Struktur eine Öffnung auf, so ist sie als Aperturblende für die Abbildung von Elektronenstrahlen geeignet, und weist die Struktur eine regelmässige Matrixanordnung von Öffnungen auf, so ist sie als Fokussierungsgitter geeignet. Die Probleme, welche für die bekannten Aperturblenden und bekannten Fokussierungsgitter aufgrund der nicht exakten Orthogonalität und der schlechten Qualität der Kanten und Ecken typisch sind, treten bei der erfindungsgemässen Struktur nicht auf, was den Eigenschaften des einkristallinen Siliciums und den ausgezeichneten Verfahren, welche für die Bearbeitung von Silicium ausgearbeitet worden sind, zu verdanken ist. Die Qualität der Kanten der erzeugten Öffnungen bzw. Fenster und die Genauigkeit, mit welcher die Kanten senkrecht aufeinanderstehen, hängt ausschliesslich von der Qualität des Siliciumeinkristalls ab, aus welchem das Siliciumplättchen erzeugt worden ist, und die Qualität dieser Siliciumeinkristalle ist heutzutage sehr gut. Auch wenn bei der beschriebenen Ausführungsform der erfindungsgemässen Struktur die Dicke des Siliciums wegen der geneigten Wände der Öffnungen im Randbereich des Fensters bzw. der Fenster ziemlich dünn ist, reicht schon eine beidseitig aufgebracht dünne, d.h. ungefähr 1 bis ungefähr 1,5 µm dicke Wolfram-Silizidauflage aus, um die Elektronen vollständig zu absorbieren. Bei der Verwendung der Struktur als erste Aperturblende wird sie stark erhitzt, dass sie ca. 90% des primären Elektronenstrahls (Elektronenstrom ca. 1 µA) absorbiert. Die bisher eingesetzten Aperturblenden aus Metall werden dabei auf 500 bis 600 °C erhitzt. Dadurch entsteht jedoch bei der erfindungsgemässen Struktur kein Problem, während beispielsweise bei Versuchen, welche die Erfinder des vorliegenden Gegenstandes mit einer Aperturblende aus Silicium mit einer Goldauflage gemacht haben, sich das Gold – aufgrund seines anderen Ausdehnungskoeffizienten und der nur mässigen Haftung von Gold auf Silicium – zum Teil stark ablöste. Die Fokussierungsgitter werden bei der Bestrahlung mit Elektronenstrahlen lokal stark erhitzt. Der Strahl mit einem Durchmesser von grössenordnungsmässig 1 µm hat eine Stromstärke von ungefähr 5 µA. Bei der erfindungsgemässen Struktur tritt auch dabei kein Problem auf, während bei Versuchen, welche die Erfinder des Gegenstandes der Anmeldung mit Fokussierungsgittern aus Silicium, welche mit Gold beschichtet waren, durchgeführt haben, sich das Gold aufgrund des hohen Temperaturgradienten, der unterschiedlichen Ausdehnungskoeffizienten von Silicium und Gold und der mässigen Haftung von Gold auf Silicium zum Teil ablöste. Bei der erfindungsgemässen Struktur tritt auch keine durch die Erhitzung verursachte Verbiegung auf, wie sie an den bekannten, aus Draht bestehenden Fokussierungsgittern festgestellt worden ist. Als weiterer Vorteil der erfindungsgemässen Struktur gegenüber den bekannten, aus Draht bestehenden Fokussierungsgittern ist anzuführen, dass die aufeinander senkrecht stehenden Kanten exakt in der gleichen Ebene liegen.

Eine insbesondere als Maske in der Röntgenstrahllithographie geeignete Ausführungsform der erfindungsgemässen Struktur ist so ausgebildet, dass der einkristalline und eine (100)-Orientierung aufweisende Siliciumkörper aus einer dünnen Schicht und aus einer diese Schicht bereichsweise unterstützenden Stützstruktur besteht, welche anders dotiert ist als die Schicht, und dass die Schicht in den Bereichen, in welchen sie nicht von der Stützstruktur unterstützt wird, eine durchgehende Öffnung bzw. durchgehende Öffnungen aufweist. Dabei ist es insbesondere günstig, wenn die Schicht $P^+$-dotiert und die Stützstruktur nicht oder nur gering dotiert ist, wenn sich in den Siliciumkörper mindestens eine wannenförmige Vertiefung erstreckt, deren Seitenwände von der Stützstruktur gebildet werden und mit der Schicht 11 einen Winkel von 54,7° bilden und deren Boden von der Schicht gebildet wird, und wenn die Metallsilizidschicht die von der Stützstruktur abgewandte Oberfläche der Schicht und die Wände der Öffnung bzw. der Öffnungen bedeckt. Mit einer solchen Maske ist man allerdings nicht in der Lage, kreisförmige bzw. in sich geschlossene Musterelemente zu übertragen, vielmehr ist dies nur möglich, wenn zwei sich ergänzende Komplementärmasken zusammenwirken. Ist jedoch in der genannten Ausführungsform der erfindungsgemässen Struktur der Siliciumkörper einseitig mit einer für Röntgenstrahlen durchlässigen Schicht, beispielsweise aus Siliciumdioxid, bedeckt, welche auch die Öffnung bzw. die Öffnungen einseitig verschliesst, und unter Umständen auf dieser Schicht noch eine ebenfalls für Röntgenstrahlen durchlässigen Schicht, beispielsweise aus Siliciumnitrid, aufgebracht ist, so ergibt sich eine Maske, mit welcher auch kreisförmige und in sich geschlossene Musterelemente übertragen werden können. Es ist vorteilhaft, sowohl eine Siliciumdioxid- als auch eine Siliciumnitridschicht aufzubringen, da bei Temperaturerhöhung eine Siliciumnitridschicht eine Zugsspannung und eine Siliciumdioxidschicht eine Druckspannung aufbaut und diese beiden Spannungen sich durch die Kombination der Schichten nicht nur weitgehend kompensieren lassen, sondern es ist auch so, dass bereits eine dünne Siliciumdioxid- und eine dünne Siliciumnitridschicht der Maske eine – insbesondere auch bei höheren Temperaturen – sehr gute Stabilität verleiht, welche im übrigen durch das Vorhandensein der $P^+$-dotierten Siliciumschicht noch beachtlich erhöht wird. Wie sich aus dem oben erwähnten Vortrag von E. Bassous u.a. ergibt, haben übereinanderliegende dünne Schichten von Siliciumdioxid und Siliciumnitrid (Gesamtdicke ca. 0,4 µm) eine höhere Transmission für Röntgenstrahlen als andere Substrate wie z.B. eine mehrere µm dicke $P^+$-Siliciummembran oder eine ca. 5 µm dicke Polyimidmembran. Die relativ hohe Durchlässigkeit von $P^+$-dotiertem Silicium für Röntgenstrahlen wird durch die dünne Metallsilizidauflage, welche auf der $P^+$-dotierten Schicht aufgebracht ist und Röntgenstrahlen genauso gut wie eine Schicht aus dem entsprechenden Metall absorbiert, überkompensiert.

Bei der Herstellung der erfindungsgemässen Struktur werden eine grosse Anzahl bekannter Verfahrensschritte angewandt. Bei dem Verfahren handelt es sich aber nicht nur um eine blosse Aneinanderreihung dieser Verfahrensschritte, vielmehr ermöglicht es die vorgenommene Auswahl und Kombination dieser Verfahrensschritte auf überraschend einfache Weise und unter Einhaltung überraschend kleiner Fertigungstoleranzen eine Struktur herzustellen, welche wesentlich günstigere Eigenschaften aufweisen als die für dieselben Anwendungen eingesetzten bekannten Strukturen.

Eine Struktur, welche beispielsweise als Aperturblende oder Fokussierungsgitter eingesetzt werden kann, wird in vorteilhafter Weise hergestellt, indem auf einen einkristallinen, beidseitig polierten flachen Siliciumkörper mit (100)-Orientierung beidseitig eine Siliciumdioxidschicht thermisch aufgewachsen wird, indem in die eine Siliciumdioxidschicht gemäss einem festgelegten Muster kreisförmige Löcher mittels reaktiven Ionenätzens geätzt werden, indem in das Siliciumplättchen unter Verwendung der geätzten Siliciumdioxidschicht als Ätzmaske anisotrop das Silicium bis zu der anderen Siliciumdioxidschicht zur Erzeugung von Öffnungen weggeätzt wird, indem die Siliciumdioxidschichten weggeätzt werden, und in dem schliesslich der Siliciumkörper durch beidseitiges Bedampfen mit einer dünnen Metallschicht eingehüllt wird und anschliessend zur Erzeugung der Silizidschicht getempert wird. Wird in den Siliciumkörper eine Öffnung geätzt, so ist die fertige Struktur als Aperturblende geeignet, wird eine Vielzahl von Öffnungen in Matrixanordnung in den Siliciumkörper geätzt, so eignet sich die fertige Struktur als Fokussierungsgitter. Zwar ist es aus dem Artikel «Fabrication of Novel Three-Dimensional Microstructures by the Anisotropic Etching of (100) and (110) Silicium» von E. Bassous in IEEE Transactions on Electron Devices, Band Ed-25, Nr. 10, Oktober 1978, Seiten 1178 ff. bekannt, in Siliciumkörpern mit (100)-Orientierung unter Verwendung von Ätzmasken mit quadratischen Öffnungen sich verjüngende Vertiefungen mit einem kreisförmigen Querschnitt durch anisotropes Ätzen zu erzeugen. Jedoch ist aus dieser Veröffentlichung nicht zu entnehmen, dass wenn die Ätzmaske aus Siliciumdioxid mittels reaktiven Ionenätzens erzeugt wird, mit dieser Methode durchgehende Öffnungen mit einer exakt quadratischen (d.h. bei einer Kantenlänge von 500 µm können sich die Längen von aufeinanderstehenden Kanten um weniger als 3 µm unterscheiden und die Orthogonalität ist hervorragend) Form und einer Kantenqualität – und zwar auch dort, wo die Kanten aneinanderstossen –, wie es mit keiner anderen Methode möglich ist, herstellbar sind.

Zur Herstellung einer beispielsweise als Maske für die Röntgenstrahllithographie geeigneten Struktur geht man in vorteilhafter Weise so vor, dass ein beidseitig polierter, einkristalliner, höchstens gering dotierter Siliciumkörper mit (100)-Orientierung einseitig stark dotiert wird, so dass eine ungefähr 1,5 bis ungefähr 3 µm dicke hochdotierte Siliciumschicht erzeugt wird, dass auf der der Siliciumschicht abgewandten Oberfläche des Siliciumkörpers eine mindestens eine Öffnung aufweisende Siliciumdioxid-Schicht hergestellt wird, dass unter Verwendung der Siliciumdioxid-Schicht als Ätzmaske das noch vorhandene, höchstens gering dotierte Silicium selektiv und anisotrop bis zur Siliciumschicht weggeätzt wird, wobei eine Stützstruktur aus nieder dotierten Bereichen des Siliciumkörpers entsteht, dass die Ätzmaske entfernt wird, dass auf der von der Sützstruktur abgewandten Oberfläche der Siliciumschicht eine dünne Schicht aus einem Material, beispielsweise aus $SiO_2$, welches für Röntgenstrahlen durchlässig ist, in dessen Gegenwart Silicium selektiv mittels reaktiven Ionenätzens entfernt werden kann und das mit Metall kein Silizid bildet, und darauf eine Schicht aus einem Material, wie z.B. $Si_3N_4$, welches für Röntgenstrahlen durchlässig ist und mit der Schicht darunter eine auch bei thermischer Belastung stabile Maskenunterlage bildet, aufgewachsen werden, dass mittels reaktiven Ionenätzens in der nicht mit Siliciumnitrid abgedeckten Siliciumdioxidschicht ein dem gewünschten Muster von durchgehenden Öffnungen entsprechendes Muster von durchgehenden Löchern erzeugt wird, dass mittels reaktiven Ionenätzens in einer Argon und Chlor enthaltenden Atmosphäre unter Verwendung des Musters von durchgehenden Löchern durchgehende Öffnungen in der Siliciumschicht erzeugt werden, wobei das Ätzen nach dem Durchätzen der Grenzschicht zur beispielsweise aus Siliciumdioxid bestehenden Schicht aufhört, dass nach dem Entfernen der Ätzmaske aus Siliciumdioxid auf die freiliegende Oberfläche der Siliciumschicht und auf die in den Öffnungen freiliegende Oberfläche der beispielsweise aus Siliciumdioxid bestehenden Schicht eine dünne Schicht aus einem Metall, wie z.B. Wolfram, welches vorzugsweise eine hohe Ordnungszahl hat und ein Silizid hoher Dichte bildet, aufgedampft wird, dass zur Bildung der Silizidschicht getempert wird und dass schliesslich das nichtumgesetzte Metall auf der beispielsweise aus Siliciumdioxid bestehenden Schicht weggeätzt wird. Die Erzeugung einer $P^+$-dotierten Siliciumschicht der Oberfläche eines niedrig oder nicht dotierten Siliciumplättchens mit dem Zweck, beim selektiven Dünnätzen des Siliciumplättchens sicherzustellen, dass in den geätzten Bereichen eine dünne Schicht mit definierter Dicke stehen bleibt, ist beispielsweise aus der europäischen Patentanmeldung EP-A-0 001 038 bekannt. Dadurch, dass bei dem hier beanspruchten Verfahren – anders als bei den bekannten Verfahren zur Herstellung von Masken für die Röntgenstrahllithographie – das Maskenmuster aus dem an sich für Röntgenstrahlen relativ gut durchlässigen Silicium mittels reaktiven Ionenätzens erzeugt wird und erst dann durch eine nachfolgende «Metallisierung» des Siliciums die notwendige Absorptionsfähigkeit für Röntgenstrahlen erzeugt wird, vermeidet man die Nachteile, die bei den bekannten Verfahren beim Elektroplattieren und beim Ionenätzen auftreten. Irsbesondere erhält man mit dem hier beschriebenen Verfahren einwandfreie Ränder der Musterelemente und das Verhältnis von Grabentiefe zur Grabenbreite kann hoch sein. Die nachträgliche «Metallisierung» des erzeugten Maskenmusters ist nur möglich, weil das Metall mit der beispielsweise aus $SiO_2$ bestehenden Schicht nicht reagiert und deshalb nach der Silizidbildung problemlos entfernt werden kann, ohne dass das gebildete Metallsilizid angegriffen wird.

Weitere vorteilhafte Ausgestaltungen der erfindungsgemässen Struktur und des erfindungsgemässen Verfahrens sind in den Unteransprüchen beschrieben.

Die Erfindung wird anhand von durch Zeichnungen erläuterten Ausführungsbeispielen beschrieben.

Es zeigen:

Fig. 1 in perspektivischer Darstellung einen Ausschnitt aus einer zum Erzeugen eines festgelegten Querschnitts eines Elektronenstrahls geeigneten Ausführungsform der erfindungsgemässen Struktur,

Fig. 2 in perspektivischer Darstellung einen Ausschnitt aus einer weiteren Ausführungsform der erfindungsgemässen Struktur, welche zur optimalen Fokussierung eines Elektronenstrahls verwendbar ist,

Fig. 3 einen Querschnitt durch einen Ausschnitt aus einer Ausführungsform der erfindungsgemässen dritten Struktur, welche als Maske bei röntgenlithographischen Anwendungen brauchbar ist,

Fig. 4A bis 4G im Querschnitt Ausschnitte aus den in den in den Fig. 1 und 2 gezeigten Strukturen in verschiedenen Stadien ihrer Herstellung und

Fig. 5A bis 5G im Querschnitt Ausschnitte aus der in der Fig. 3 gezeigten Struktur in verschiedenen Stadien ihrer Herstellung.

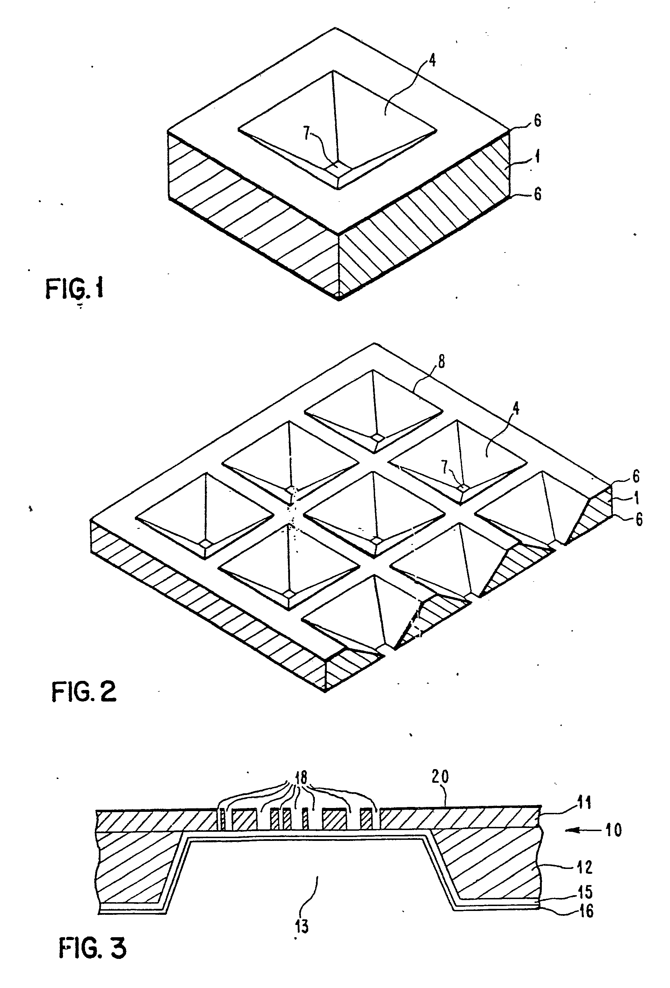

In der Fig. 1 ist in perspektivischer Darstellung ein Ausschnitt aus einem zwischen etwa 100 und etwa 300 µm, bevorzugt um 400 µm, dicken, flachen Siliciumkörper 1 gezeigt, welcher eine durchgehende Öffnung 4 aufweist. Die obere und die untere Oberfläche des Siliciumkörpers 1 haben eine (100)-Orientierung. Die Öffnung 4 hat die Form einer parallel zur Grundfläche abgeschnittenen Pyramide mit quadratischem Grundriss und einem Steigungswinkel vom 54,7°. Ein quadratisches Fenster 7 in der einen Oberfläche des Siliciumkörpers 1, welche die lichte Weite der Öffnung 4 bestimmt, hat exakt senkrecht aufeinanderstehende Kanten, welche sehr glatt sind, und die Ecken, welche die senkrecht aufeinanderstehenden Kanten miteinander bilden, sind scharf. Die Grösse des Fensters ist ungefähr $500 \times 500$ µm². Kritisch ist nicht die Kantenlänge, vielmenr die Längendifferenz zwischen senkrecht aufeinanderstehenden Kanten. Im Fenster 7 beträgt diese Differenz $< 3$ µm. Die Oberflächen des Siliciumkörpers 1 einschliesslich der Lochwände 4 bestehen aus einer $WSi_2$-Schicht 6, welche zwischen etwa 1 und etwa 1,5 µm dick ist. Ausser Wolfram können auch beispielsweise Molybdän, Tantal, Rhonium, Niob, Iridium, Platin und Palladium die metallische Komponente des Silicids bilden. Diese Metalle haben eine hohe Ordnungszahl und bilden ein Silizid hoher Dichte.

Die in der Fig. 1 gezeigte Struktur bzw. das Fenster 7 in der Struktur lässt sich als Aperturblende in einer Elektronenstrahl-Bestrahlungsvorrichtung, in welcher ein zu bestrahlendes Substrat ohne Verwendung einer Maske selektiv bestrahlt wird, verwenden.

Silicium ist zwar ein sehr günstiges Material, wenn es darum geht, Aperturblenden mit festgelegten Abmessungen innnerhalb sehr kleiner Toleranzen herzustellen. Es hat jedoch den Nachteil, dass es für energiereiche Strahlung, insbesondere dann, wenn – wie im Randbereich des Fensters 7 – die Schichtdicke relativ dünn ist, gut durchlässig ist. Dieses Problem löst die Metallsilizidschicht 6, welche bereits dann, wenn ihre Schichtdicke grössenordnungsmässig im µm-Bereich liegt, Elektronenstrahlen mit einer Energie von $\leq = 25$ keV vollständig absorbiert. Da durch das Fenster 7 die auftreffende Strahlung ungeschwächt hindurchgeht, weist also eine Aperturblende, wie sie in der Fig. 1 dargestellt ist, einen praktisch unendlich grossen Kontrast auf.

Die in der Fig. 2 gezeigte Struktur ist im Prinzip gleich wie die in der Fig. 1 gezeigte Struktur aufgebaut, von der sie sich nur dadurch unterscheidet, dass sie nicht nur eine Öffnung 4, sondern viele Öffnungen in einer regelmässigen Matrixanordnung aufweist. Die in der Fig. 2 gezeigte Struktur lässt sich vorteilhaft als Fokussierungsgitter einsetzen. Die in der Fig. 2 gezeigte Lochmatrix hat mindestens die Grösse der Fläche, welche mit einem optimal fokussierten Strahl bestrahlt werden soll. Typischerweise haben bei einem Strahldurchmesser in der Grössenordnung von 1 μm die Öffnungen 4 einen grössten Querschnitt 8 zwischen etwa 415 und etwa 450 μm und einen Öffnungsabstand von 100 μm, wobei das Siliciumplättchen 6 ≤ 200 μm und bevorzugt zwischen etwa 100 und etwa 150 μm dick ist. Zur Messung der Fokussierung am Ort der Öffnungen 4 wird der Elektronenstrahl jeweils über zwei zueinander senkrecht liegende Kanten der Fenster 7 senkrecht zu den Kanten geführt und dabei wird die Intensität und damit die Intensitätsverteilung im Strahl durch die Fenster 7 hindurch gemessen.

Die Fig. 3 zeigt im Querschnitt einen Ausschnitt aus einer nicht massstabsgerecht gezeichneten Struktur, welche insbesondere als Maske für die Röntgenstrahllithographie einsetzbar ist. Die Struktur besteht im wesentlichen aus einem strukturierten einkristallinen Flachen Siliciumkörper mit (100)-Orientierung. Das Maskenmuster besteht aus Öffnungen 18, welche durch eine ungefähr 1,5 bis ungefähr 3 μm dicke Schicht 11 hindurchgehen und Wände aufweisen, welche zur Maskenoberfläche im wesentlichen senkrecht sind. Die kleinsten lateralen Abmessungen der Musterelemente, welche mit der Maske übertragen werden sollen und denen entsprechend auch die Öffnungen 18 dimensioniert sein müssen, sind ≥ 0,2 μm. In den Bereichen, in welchen sich keine Öffnungen 18 befinden, ist die Schicht 11 um eine ungefähr 250 μm dicke Stützstruktur 12 verstärkt. Die Schicht 11 unterscheidet sich von der Stützstruktur 12 durch die Dotierung. Beispielsweise können die Schicht 11 P$^+$- und die Stützstruktur 12 P- oder N-dotiert sein. Ist die Schicht 11 mit Bor dotiert, so ist die Oberflächendotierung an der Schichtoberseite (d. h. an der von der Stützstruktur 12 abgewandten Seite) > 10$^{20}$ Boratome/cm$^2$ und an der Schichtunterseite ungefähr 7 × 10$^{19}$ Boratome/cm$^3$. Eine andere mögliche Dotierungskombination ist eine N$^+$-Dotierung der Stützstruktur 12 und eine N-Dotierung der Schicht 11. Die Spannfläche der Schicht 11 zwischen Pfeilern der Stützstruktur 12 kann ohne weiteres 5 × 5 cm gross sein, jedoch sollte dann, wenn die Maske zur Herstellung von Strukturen im Submikronbereich eingesetzt werden soll, die maximale Spannfläche eine Grösse von ungefähr 4 × 4 cm$^2$ nicht überschreiten. Die Seitenflanken der Stützstruktur 12 bilden mit der Maskenoberfläche einen Winkel von 54,7°. Die Stützstruktur 12 und die Unterseite der Schicht 11 sind mit einer ungefähr 0,3 μm dicken SiO$_2$-Schicht 15 und mit einer darauf aufgebrachten ungefähr 0,1 μm dicken Si$_3$N$_4$-Schicht 16 bedeckt, welche auch die Öffnungen 18 einseitig verschliessen. Dank der für Röntgenstrahlung gut durchlässigen SiO$_2$–Si$_3$N$_4$-Schichtkombination ist es möglich, dass das Maskenmuster auch Musterelemente enthält, welche vollständig von Öffnungen 18 umgeben sind. Die Oberseite der Schicht 11 bedeckt eine ungefähr 1 bis ungefähr 1,5 μm dicke Schicht aus einem Metallsilizid, dessen metallische Komponente bevorzugt aus Wolfram, beispielsweise aber auch aus Molybdän, Tantal, Rhenium, Niob, Iridium, Platin oder Paladium bestehen kann. Grundsätzlich sind zur Bildung eines Silizids hoher Dichte fähige Metalle mit einer hohen Ordnungszahl als Bestandteil des Silizids am besten geeignet. Das Silizid kann auch die Wände der Öffnungen 18 bedecken.

Die beschriebene Maske zeichnet sich durch eine gute mechanische Stabilität und einen hohen Kontrast aus. Der Kontrast liegt bei einer Röntgenstrahlwellenlänge im Bereich zwischen etwa 0,5 und etwa 5 nm und einer Röntgenstrahlintensität von mehreren 1000 mJ/cm$^2$ für die beschriebene Maskenstruktur bei 8 bis 10.

Bei der Verwendung der beschriebenen Maskenstruktur zum selektiven Bestrahlen eines Substrats mit Röntgenstrahlung ist die Oberseite der Schicht 11 dem zu belichtenden Substrat zugewandt, wobei bei Verwendung einer aus einer konventionellen Röntgenröhre stammenden Strahlung mittels eines Abstandsrings ein Abstand zwischen Maske und Substrat von maximal 20 μm eingehalten wird, während bei Verwendung einer von einem Synchrotron stammenden und damit aus einem Bündel paralleler Strahlen bestehender Strahlung der Abstand zwischen Maske und Substrat mehrere zehntel Millimeter gross sein kann.

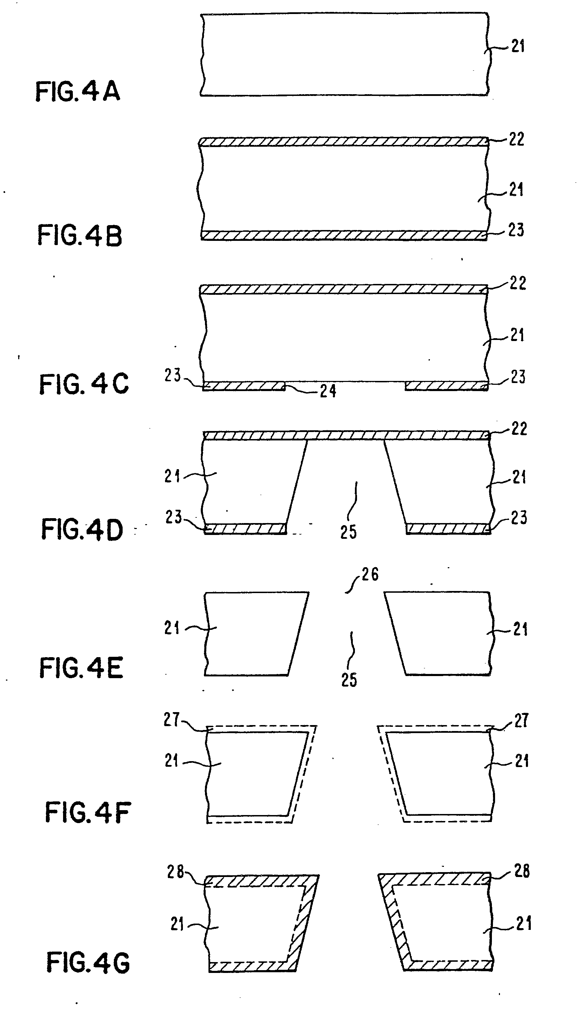

Anhand der Fig. 4A bis 4G soll im folgenden die Herstellung einer Struktur beschrieben werden, wie sie beispielsweise in den Fig. 1 und 2 dargestellt ist.

Ausgegangen wird von einem beidseitig polierten einkristallinen flachen Siliciumkörper 21 mit (100)-Orientierung (siehe Fig. 4A). Je geringer die Oberflächenrauhigkeit der Oberflächen des Siliciumkörpers 21 ist, umso präziser sind die Kanten der in einem späteren Verfahrensschritt geätzten Fenster, welche den Fenstern 7 in den Fig. 1 und 2 entsprechen. Die Dicke des Siliciumkörpers 21 liegt bei einer Verwendung der herzustellenden Struktur als Fokussierungsgitter bei ≤ 200 μm und bevorzugt zwischen etwa 100 und 150 μm und bei einer Verwendung der herzustellenden Struktur als Aperturblende zwischen etwa 100 und etwa 400 μm und bevorzugt bei ungefähr 400 μm. Auf der Unter- und der Oberseite des Siliciumkörpers 21 wird je eine etwa 1 μm dicke Siliciumdioxidschicht 22 bzw. 23 entweder durch thermische Oxidation oder durch Kathodenzerstäuben aufgebracht (siehe Fig. 4B). In die SiO$_2$-Schicht 23 auf der Unterseite wird mindestens eine kreisförmige Öffnung 24 geätzt. Wie sich aus dem obengenannten Artikel von E. Bassous in IEEE Transcations on Electron Devices ergibt, besitzt eine Ätzmaske mit kreisförmigen Fenstern den Vorteil, dass bei einem nachfolgenden anisotropen Nassätzen die SiO$_2$-Kantenqualität in der Öffnung 24 an den vier Punkten, an denen die vier Schnittlinien zwischen der (100)- und den (111)-Ebenen die Maskenkante berühren, die Qualität der herzustellenden Fenster beeinflusst, d. h. Fehler im SiO$_2$-Maskenrand wirken sich nur dort aus, wo die vier Schnittlinien die Maskenkante in der Öffnung 24 tangieren. Anders als im Stand der Technik werden die Öffnungen 24 mittels reaktiven Ionenätzens unter Verwendung einer Photolackmaske, welche beispielsweise aus dem von der Firma Shipley unter dem Handelsnamen AZ 1350J vertriebenen Positivlack hergestellt wird, aus der SiO₂-Schicht 23 herausgeätzt. Dabei werden die freiliegenden Bereiche der SiO₂-Schicht 23 mittels einer Glimmentladung in einer CF₄ und H₂ enthaltenden Atmosphäre entfernt. Bevorzugte Bedingungen dabei sind: Mengenverhältnis CF₄ : H₂ ungefähr 60 : 40, HF-Leistungsdichte 0,2 Watt/cm², Gesamtdruck 2,66 µbar, Gasfluss 20 Standard-ccm/Min. Das Ergebnis dieses Verfahrensschrittes zeigt die Fig. 4C. Die in den Öffnungen 24 freiliegenden Bereiche des Siliciumkörpers 21 werden nun mittels eines anisotrop wirkenden Ätzmittels entfernt. Anisotrop heisst dabei, dass die (100)-Ebenen erheblich schneller geätzt werden als die (111)-Ebenen. Geeignete Ätzmittel sind dabei eine wässrige Lösung von KOH, welche die (100)-Ebenen bis zu 400mal schneller ätzt als die (111)-Ebenen, und eine Mischung aus Äthylendiamin, Brenzkatechin und Wasser, welche die (100)-Ebenen 20 bis 40mal schneller ätzt als die (111)-Ebenen. Eine günstige Lösung enthält 50 Gew.-% KOH und wird bei 50°C eingesetzt. Eine günstige Mischung enthält auf 35 ml Äthylendiamin, 4 g Brenzkatechin und 8 ml Wasser und wird bei 118°C eingesetzt. Die Wände der beim Ätzen entstehenden Öffnungen 25 bilden mit den (100)-Ebenen einen Winkel von 54,7°. Um ein dem Fenster 7 in den Fig. 1 und 2 entsprechendes Fenster in der Oberseite des Siliciumkörpers 21 mit bestimmten Abmessungen zu erzeugen, muss der Durchmesser der Öffnung 24 unter Berücksichtigung dieses Winkels, sowie der Dicke des Siliciumkörpers 21 und der unterschiedlichen Geschwindigkeiten, mit denen (100)- und (111)-Ebenen geätzt werden, festgelegt werden. Die nach dem Ätzen vorliegende Struktur zeigt die Fig. 4D.

Anschliessend werden die Siliciumdioxidschichten 22 und 23 entfernt, wobei die in der Fig. 4E gezeigte Struktur mit dem Fenster 26 entsteht.

Die in der Fig. 4E gezeigte Struktur wird anschliessend mit einer Metallsilizidschicht überzogen. Als metallische Komponente des Silizids wird dabei vorzugsweise Wolfram verwendet. Daneben sind aber auch noch eine Reihe weiterer Schwermetalle hoher Ordnungszahl, wie z.B. Molybdän, Tantal, Rhenium, Niob, Iridium, Platin oder Palladium, welche zur Silizidbildung in der Lage sind und deren Silizid eine hohe Dichte hat, als metallische Komponente des Silizids brauchbar. Eine Möglichkeit das Silizid herzustellen besteht darin, zunächst auf die Oberseite des Siliciumkörpers 21 und auf seine Unterseite und auf die Wände der Öffnung 25 eine dünne, typischerweise ungefähr 0,5 µm dicke Schicht 27 (siehe Fig. 4F) aus einem Metall, wie z.B. Wolfram, aufzudampfen, wobei der Siliciumkörper 21 eine Temperatur von ungefähr 150°C hat. Anschliessend wird bei 1000°C in einer Intertgas-Atmosphäre so lange getempert, bis sich aus dem Metall und Silicium von der Oberfläche des Siliciumkörpers 21 quantitativ das Silizid (siehe die Schicht 28 in der Fig. 4G) gebildet hat. Um eine 0,3 µm dicke Wolframschicht quantitativ in Wolfram-Silizid umzuwandeln, muss ungefähr 30 Minuten lang getempert werden. Die Umwandlung dickerer Wolfram-Schichten dauert entsprechend länger. Es ist auch möglich, zur Silizidbildung auf den auf 150°C erhitzten Siliciumkörper 21 beidseitig zunächst eine dünne Siliciumschicht und anschliessend das Metall, wie z.B. Wolfram, und Silicium im für die Silizidbildung ungefähr richtigen Atomverhältnis aufzudampfen. Anschliessend wird wie oben getempert. Kleine Abweichungen vom richtigen, für die Silizidbildung notwendigen Atomverhältnis werden dabei durch Aufnahme von Silicium aus der Siliciumunterlage bzw. Abgabe von Silicium an diese ausgeglichen.

Die Silizidschicht 28, welche chemisch mit dem Siliciumkörper 21 verbunden ist, hat eine ausgezeichnete «Haftung». Die Silizidschicht 28, welche, wenn sie aus WSi₂ besteht und bei ihrer Herstellung von einer ungefähr 0,5 µm dicken Wolframschicht 26 ausgegangen worden ist, hat eine Dicke von ungefähr 1 bis 1,5 µm. Diese Dicke ist ausreichend, um Elektronen mit einer Energie von ungefähr 25 keV vollständig zu absorbieren.

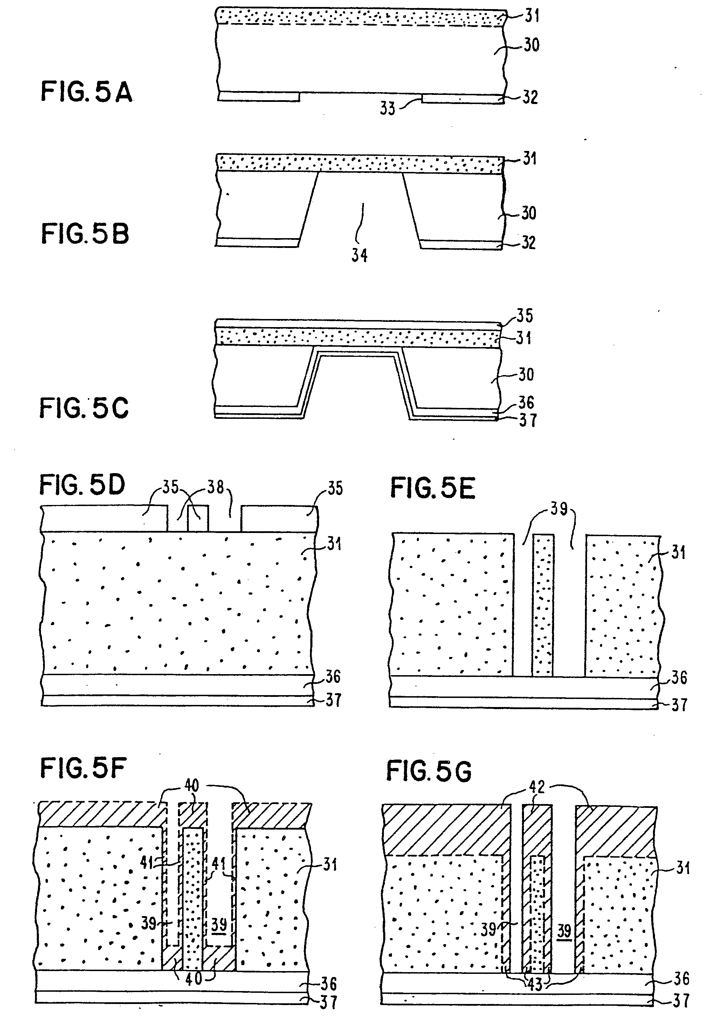

Anhand der Fig. 5A bis 5G soll nun die Herstellung einer Struktur, wie sie beispielsweise in der Fig. 3 schematisch dargestellt ist, beschrieben werden.

Ausgegangen wird von einem nicht oder schwach dotierten einkristallinen Siliciumkörper 30 mit (100)-Orientierung, welches typischerweise eine Dicke von ungefähr 250 µm hat, aber auch zwischen ungefähr 100 und 400 µm dick sein kann. Die eine Oberfläche des Siliciumkörpers 30 (im folgenden Rückseite genannt), wird mit einer 0,5 bis 1 µm dicken Siliciumdioxidschicht 32 beispielsweise durch thermische Oxidation versehen. Anschliessend wird die der Rückseite abgewandte Oberfläche (im folgenden Vorderseite genannt) des Siliciumkörpers 30 mit einer eine P⁺-Leitfähigkeit vermittelnden Verunreinigung hochdotiert, wobei die Schicht 32 sich bildet. Es ist günstig, als Verunreinigung Bor zu verwenden. Die Bordotierung an der Siliciumoberfläche liegt typischerweise bei > 10²⁰ Atomen/cm³ und in einer Tiefe, die zwischen ungefähr 1,5 und ungefähr 3 µm liegt, bei 7 × 10¹⁹ Atomen/cm³. Nun wird in der Siliciumdioxidschicht 32 mindestens eine Öffnung 33 erzeugt. Die lateralen Abmessungen der Öffnung bzw. der Öffnungen 33 sind bestimmt durch die gewünschten lateralen Abmessungen der im nächsten Verfahrensschritt in den Siliciumkörper 30 hineinzuätzenden wannenförmigen Vertiefungen.

Unter Verwendung der Siliciumdioxidschicht 32 als Ätzmaske wird nun der Siliciumkörper 30 von der Rückseite aus dünn geätzt. Zum Ätzen wird in vorteilhafter Weise die oben angegebene Mischung aus Äthylendiamin, Brenzkatechin und Wasser unter den dort angegebenen Bedingungen eingesetzt. Der Ätzvorgang senkrecht zur Körperoberfläche kommt praktisch vollständig zum Stillstand, wenn so viel Material abgetragen worden ist, dass die Ätzlösung von der Rückseite her dort mit der P⁺-dotierten Schicht 31 in Berührung kommt, wo deren Verunreinigungskonzentration $\geq 7 \times 10^{19}$ Atome/cm³ ist. Die dann vorliegende, mindestens eine Vertiefung 34 aufweisende Struktur zeigt im Querschnitt ausschnittsweise die Fig. 5B. Die Struktur weist mindestens eine Siliciummembrane auf, welche ein Bereich der P⁺-dotierten Schicht 31 ist, welche je nach den Bedingungen beim Bordotieren zwischen ungefähr 1,5 und ungefähr 3 µm dick ist, welche unter mässiger Zugspannung steht und aufgrund ihres Einkristallcharakters eine ausgezeichnete mechanische Stabilität besitzt, so dass ihre Abmessungen ohne weiteres $5 \times 5$ cm² sein können, jedoch – insbesondere wenn die herzustellende Struktur bei der Erzeugung von Strukturen mit Elementen im Submikronbereich Verwendung finden soll – nicht grösser als etwa $4 \times 4$ cm² sein sollten. Die Seitenflanken der stehengebliebenen niederdotierten Bereiche des Siliciumkörpers 30, welche als Stützstruktur für die Schicht 31 dienen, haben Seitenflanken, welche mit der Plättchenoberfläche einen Winkel von 54,7° bilden.

Anschliessend wird die Siliciumdioxidschicht 32 entfernt. Dann werden auf der Vorderseite der Schicht 31 eine 0,8 µm dicke Siliciumdioxidschicht 35 und auf der Rückseite der Schicht 31 und auf der Stützstruktur 30 eine ungefähr 0,3 µm dicke Siliciumdioxidschicht 36 und auf dieser eine ungefähr 0,1 µm dicke Siliciumnitridschicht 37 aufgebracht. Die dann vorliegende Struktur zeigt im Querschnitt ausschnittsweise die Fig. 5C. Das Aufbringen der Siliciumdioxidschichten 35 und 36 erfolgt beispielsweise mittels Kathodenzerstäubens oder mittels chemischen Niederschlagens aus der Dampfphase bei Temperaturen unterhalb 600 °C. Die Siliciumnitridschicht 37 wird beispielsweise mittels chemischen Niederschlagens aus der Dampfphase bei Temperaturen unterhalb 600 °C hergestellt.

Um die bei den folgenden Verfahrensschritten interessierenden Details besser zu illustrieren, zeigen die Fig. 5D bis 5G – anders als die Fig. 5A bis 5D, welche Querschnitte durch die gesamte Dicke des Halbleiterkörpers darstellen – vergrösserte Ausschnitte aus dem Bereich der Vorderseite der herzustellenden Struktur.

In der SiO₂-Schicht 35 auf der Vorderseite der Schicht 31 wird nun mittels eines lithographischen Ätzverfahrens ein Muster von Öffnungen 38 erzeugt, wobei die dabei notwendige Maske aus einem elektronenstrahlempfindlichen Lack, vorzugsweise mittels eines Elektronenstrahl-Mustergenerators strukturiert wird und das Ätzen des Siliciumdioxids vorzugsweise mittels reaktiven Ionenätzens in einer Glimmentladung durchgeführt wird. Bei reaktiven Ionenätzen ist es günstig, wenn in einer CF₄ und H₂ (vorzugsweise im Mengenverhältnis von 60 : 40) enthaltenden Atmosphäre von einem Gesamtdruck von ungefähr 2,66 µbar bei einem Gesamtgasfluss von 20 Standard-cm³/Min. und einer HF-Leistungsdichte von ungefähr 0,2 Watt/cm² in einem Diodensystem gearbeitet wird. Die in diesem Stadium vorliegende Struktur zeigt im Querschnitt ausschnittsweise die Fig. 5D. Öffnungen 38 in der SiO₂-Schicht 35 befinden sich nur über den Bereichen der Schicht 31, welche eine Siliciummembran bilden.

Unter Verwendung des Musters von Öffnungen 38 in der Siliciumdioxidschicht 35 werden mittels reaktiven Ionenätzens in einer Glimmentladung bis zur Siliciumdioxidschicht 36 durchgehende Löcher 39 in die Schicht 31 geätzt. Vorzugsweise wird beim Ätzprozess in einem Diodensystem, welches eine aus Argon und Chlor (vorzugsweise im Mengenverhältnis von 90 : 10) bestehende Atmosphäre enthält, bei einem Gesamtdruck von 2,66 µbar und einer Leistungsdichte von 0,2 Watt/cm² gearbeitet. Unter diesen Bedingungen liegt das Verhältnis der Geschwindigkeiten, mit welchen SiO₂- und Si geätzt werden bei 1 : 10, d.h., dass P⁺-Silicium ungefähr 10mal so schnell wie Siliciumdioxid geätzt wird. Dadurch ist es ohne weiteres möglich, 0,5 µm breite Linien 4 µm tief in das Silicium hineinzuätzen, wenn man mit einer ca. 0,8 µm dicken SiO₂-Ätzmaske beginnt. Das 1 : 10-Verhältnis der Ätzgeschwindigkeiten ist auch deshalb vorteilhaft, weil dann das Ätzen an der Siliciumdioxidschicht 36 praktisch zum Stillstand kommt. Die nach dem Ätzen und dem Ablösen der Siliciumdioxidschicht 35 vorliegende Struktur ist im Querschnitt ausschnittsweise in der Fig. 5E gezeigt.

Auf der Vorderseite der Schicht 31 wird nun eine Metallsilizidschicht erzeugt. Dabei wird in derselben Weise wie bei der Erzeugung der Metallsilizidschicht, welche im Zusammenhang mit den Fig. 4F und 4G weiter oben beschrieben worden ist, vorgegangen. Unterschiede zu dem oben beschriebenen Verfahren bestehen nur insofern, als im vorliegenden Fall nur die Vorderseite der Schicht 31 mit einem Metall bedampft wird und die zweite Möglichkeit, d.h. das gleichzeitige Aufdampfen von dem Metall und von Silicium aus zwei Quellen, nicht anwendbar ist. Für die Silizidbildung sind auch die oben genannten günstigen Metalle sehr gut geeignet, da sie alle eine für eine Absorbtion der Röntgenstrahlen günstige hohe Ordnungszahl haben und ein Silizid hoher Dichte bilden. Die nach dem Aufdampfen einer Metallschicht 40 bzw. 41 (beispielsweise aus Wolfram) vorhandene Struktur zeigt die Fig. 5F ausschnittsweise im Querschnitt. Man sieht, dass das Metall nicht nur auf der Oberseite der Siliciumschicht 31 abgeschieden worden ist, sondern auch auf der Siliciumdioxidschicht 36 in den Öffnungen 39 (Metallschicht 40) und – wenn auch mit geringerer Schichtdicke – auf den Wänden der Öffnungen 39 (Metallschicht 41). Die Dicke der Metallschicht 40 wird entsprechend dem gewünschten Kontrast festgelegt.

Anschliessend wird in derselben Weise wie oben beschrieben getempert, wobei das Metall, beispielsweise das Wolfram, welches mit Silicium in Kontakt ist, unter Bildung einer stöchiometrisch zusammengesetzten Metallsilizidschicht 42 bzw. 43, beispielsweise einer aus WSi₂ bestehenden Schicht, reagiert. Nach der Bildung der Metallsilizidschichten 42 bzw. 43 auf der Siliciumschicht 31 liegt das Metall auf dem SiO₂ immer noch unverändert vor und lässt sich deshalb leicht nasschemisch selektiv wegätzen. Die Struktur nach der Bildung der Metallsilizidschichten 42 bzw. 43 und dem Wegätzen des Metalls auf der Siliciumdioxidschicht 36 zeigt ausschnittsweise im Querschnitt die Fig. 5G. Wie schon ausgeführt, wird beim Metallbedampfen auch Metall auf den Wänden der Öffnungen 29 abgeschieden, und infolgedessen bildet sich auf den Wänden der Öffnungen 39 beim Tempern auch die Metallsilizidschicht 43. Dies wird an sich nicht angestrebt, insbesondere deshalb, weil dadurch eine Veränderung des Querschnitts der Öffnungen 39 parallel zur Oberfläche der Siliciumschicht 31 nicht völlig ausgeschlossen werden kann. Die Silizidbildung an den Wänden der Öffnungen 39 ist jedoch nicht kritisch. Zunächst kann durch eine entsprechende Festlegung der Aufdampfbedingungen erreicht werden, dass nur sehr wenig Metall sich auf den Wänden der Öffnungen 39 niederschlägt. In den Fällen, in denen die dann noch auftretende Dimensionsveränderung beachtlich ist, können entweder vor dem Aufdampfen des Metalls in einem Trockenätzprozess, beispielsweise mit $XeF_2$, isotrop einige zehntel µm Si weggeätzt werden oder wird die durch die Silizidbildung verursachte Verkleinerung der Muster durch eine entsprechende Vergrösserung der Löcher 38 in der Siliciumdioxidmaske 35 kompensiert.

**Patentansprüche**

1. Struktur, welche einen flachen einkristallinen Siliciumkörper (1, 10) mit mindestens einer durchgehenden Öffnung (4, 18) und eine den Siliciumkörper (1, 10) mindestens einseitig kontaktierende und bedeckende, dünne Schicht (6, 20) enthält, dadurch gekennzeichnet, dass die dünne Schicht (6, 20) aus dem Silizid eines Schwermetalls besteht, und das Metallsilizid mit dem Silicium über chemische Bindung verbunden ist.

2. Struktur nach Anspruch 1, dadurch gekennzeichnet, dass als metallische Komponente des Silizids ein Metall dient, welches eine hohe Ordnungszahl und dessen Silizid eine hohe Dichte hat.

3. Struktur nach Anspruch 2, dadurch gekennzeichnet, dass das Metall aus der Gruppe Wolfram, Molybdän, Tantal, Rhenium, Niob, Iridium, Platin und Paladium ausgewählt ist.

4. Struktur nach einem der Ansprüche 1 bis 3, dadurch gekennzeichnet, dass der Siliciumkörper (1, 10) aus einem einkristallinen Siliciumplättchen mit (100)-Orientierung besteht.

5. Struktur nach Anspruch 4, dadurch gekennzeichnet, dass der Siliciumkörper (1) mindestens eine durchgehende Öffnung (4) aufweist, welche parallel zur Plättchenoberfläche einen quadratischen Querschnitt hat und deren Wände mit der Plättchenoberfläche einen Winkel von ungefähr 54,7° bildet und dass die Metallsilizidschicht (6) die untere und die obere Oberfläche des Siliciumplättchens und die Wände der Öffnung (4) bzw. der Öffnungen (4) bedeckt.

6. Struktur nach einem der Ansprüche 1 bis 4, dadurch gekennzeichnet, dass der Siliciumkörper (10) aus einer dünnen Schicht (11) und aus einer die Schicht (11) bereichsweise unterstützenden Stützstruktur (12) besteht, welche anders dotiert ist wie die Schicht (11) und dass die Schicht (11) in den Bereichen, in welchen sie nicht von der Stützstruktur (12) unterstützt wird, eine durchgehende Öffnung (18) bzw. Öffnungen (18) aufweist.

7. Struktur nach Anspruch 6, dadurch gekennzeichnet, dass die Schicht (11) $P^+$-dotiert und die Stützstruktur (12) nicht oder nur gering dotiert ist, da sich in den Siliciumkörper (10) hinein mindestens eine wannenförmige Vertiefung (13) erstreckt, deren Seitenwände von der Stützstruktur (12) gebildet werden und mit der Schicht (11) einen Winkel von 54,7° bilden und deren Boden von der Schicht (11) gebildet wird und dass die Metallsilizidschicht (20) die von der Stützstruktur (12) abgewandte Oberfläche der Schicht (11) und u. U. auch die Wände der Öffnung (18) bzw. der Öffnungen (18) bedeckt.

8. Struktur nach Anspruch 7, dadurch gekennzeichnet, dass der Siliciumkörper einseitig mit einer für Röntgenstrahlen durchlässigen Schicht (15), beispielsweise aus Siliciumdioxid bedeckt ist, welche auch die Öffnung (18) bzw. die Öffnungen (18) einseitig verschliesst und dass unter Umständen auf der Schicht (15) noch eine – ebenfalls für Röntgenstrahlen durchlässige – Schicht (16), beispielsweise aus Siliciumnitrid, aufgebracht ist.

9. Verfahren zum Herstellen einer Struktur nach einem der Ansprüche 1 bis 8, wobei auf den mit durchgehenden Öffnungen (25, 39) versehenen flachen Siliciumkörper (21, 30) mindestens einseitig eine dünne Schicht (27, 40) aufgebracht wird, dadurch gekennzeichnet, dass die dünne Schicht (27, 40) aus dem für die Silizidbildung bestimmten Metall oder aus einer das Metall und Silicium im für die Silizidbildung richtigen Verhältnis enthaltenen Mischung erzeugt wird und anschliessend bis zur vollständigen Umwandlung des auf dem Silicium aufliegenden Metalls in das Silizid getempert wird.

10. Verfahren nach Anspruch 9, dadurch gekennzeichnet, dass bei der Herstellung der durchgehenden Öffnungen (25, 39) der Siliciumkörper (21, 30), ausgehend von der einen Oberfläche selektiv entweder vollständig durchgeätzt wird oder zunächst soweit gedünnt wird, dass in den geätzten Bereichen nur noch eine dünne Schicht stehenbleibt und in die dünngeätzten Bereiche dann durchgehende Öffnungen (39) geätzt werden.

11. Verfahren nach Anspruch 9 oder 10, dadurch gekennzeichnet, dass vor dem Erzeugen der durchgehenden Öffnungen (25, 39) auf diejenige Oberfläche des Siliciumkörpers (21, 29) bis zu der durchgeätzt wird, mindestens eine Schicht (22, 36), die beispielsweise aus Siliciumdioxid besteht, aufgebracht wird.

12. Verfahren nach einem der Ansprüche 9 oder 10, dadurch gekennzeichnet, dass auf einen beidseitig polierten Siliciumkörper (21) mit (100)-Orientierung beidseitig eine Siliciumdioxidschicht (22 bzw. 23) thermisch aufgewachsen wird, dass vor dem vollständigen Durchätzen des Siliciumkörpers (21) in die Siliciumdioxidschicht (23) gemäss einem festgelegten Muster kreisförmige Löcher (24) mittels reaktiven Ionenätzens geätzt werden, dass das Durchätzen unter Verwendung der geätzten Siliciumdioxidschicht (23) als Ätzmaske und anisotrop erfolgt, dass die Siliciumdioxidschichten (22 und 23) weggeätzt werden und dass vor dem Tempern zum Erzeugen des Silizids durch beidseitiges Bedampfen der Siliciumkörper (21) mit einer dünnen Metallschicht (27) eingehüllt wird.

13. Verfahren nach einem der Ansprüche 9 oder 10, dadurch gekennzeichnet, dass ein beidseitig polierter, höchstens gering dotierter Siliciumkörper (30) mit (100)-Orientierung einseitig bordotiert wird, so dass eine ungefähr 1,5 bis ungefähr 3 µm dicke Siliciumschicht (31), deren Dotierung überall $\geq 7\,M\,10^{19}$ Boratome/cm$^3$ ist, erzeugt wird, dass auf der der Siliciumschicht (31) abgewandten Oberfläche des Siliciumkörpers (30) eine mindestens eine Öffnung (33) aufweisende Siliciumdioxidschicht (32) hergestellt wird, dass beim Dünnätzen unter Verwendung der Siliciumdioxidschicht (32) als Ätzmaske das noch vorhandene, höchstens gering dotierte Silicium anisotrop bis zur Siliciumschicht (31) weggeätzt wird, wobei eine Stützstruktur aus nieder dotierten Bereichen des Siliciumplättchens (30) entsteht, dass die Ätzmaske (32) entfernt wird, dass auf von der Stützstruktur abgewandten Oberfläche der Siliciumschicht (31) eine dünne Siliciumdioxidschicht (35) und auf der Stützstruktur und auf der freigeätzten Oberfläche der Siliciumschicht (31) ebenfalls eine dünne Schicht (36) aus einem Material, beispielsweise SiO$_2$, welches für Röntgenstrahlen durchlässig ist, in dessen Gegenwart Si mittels reaktiven Ionenätzens geätzt werden kann und das mit Metall kein Silizid bildet, und darauf eine Schicht (37) aus einem Material, beispielsweise aus Si$_3$N$_4$, welches für Röntgenstrahlen durchlässig ist und mit der darunterliegenden Schicht eine auch bei thermischer Belastung stabile Maskenunterlage bildet, aufgewachsen werden, dass mittels reaktiven Ionenätzens in der Siliciumdioxidschicht (35) eine dem gewünschten Muster von durchgehenden Öffnungen entsprechendes Muster von durchgehenden Löchern (38) erzeugt wird, dass mittels reaktiven Ionenätzens in einer Argon und Chlor enthaltenden Atmosphäre unter Verwendung des Musters von durchgehenden Löchern (38) durchgehende Öffnungen (39) in der beim Dünnätzen stehengebliebenen Siliciumschicht (31) erzeugt werden, wobei das Ätzen nach dem Durchätzen der Grenzschicht zur Schicht (36) aufhört, dass nach dem Entfernen der Siliciumdioxidschicht (35) und vor dem Tempern das zur Silizidbildung fähige Metall, wie z.B. Wolfram, auf die freiliegende Oberfläche der Siliciumschicht (31) und auf die in den Öffnungen (39) freiliegende Oberfläche der Schicht (36) in dünner Schicht (40 bzw. 41) aufgedampft wird, und dass schliesslich das nicht umgesetzte Metall auf der Schicht (36) weggeätzt wird.

## Claims

1. Structure containing a shallow monocrystalline silicon body (1, 10) with at least one through opening (4, 18), and a thin layer (6, 20) contacting and covering the silicon body (1, 10) on at least one side, characterized in that the thin layer (6, 20) consists of the silicide of a heavy metal, and that the metal silicide is chemically bonded to the silicon.

2. Structure as claimed in claim 1, characterized in that as a metallic component of the silicide a metal is used which has a high atomic number, and whose silicide is of a high density.

3. Structure as claimed in claim 2, characterized in that the metal is selected of the group consisting of tungsten, molybdenum, tantalum, rhenium niobium iridium, platinum, and palladium.

4. Structure as claimed in one of claims 1 to 3, characterized in that the silicon body (1, 10) consists of a monocrystalline silicon wafer with (100)-orientation.

5. Structure as claimed in claim 4, characterized in that the silicon body (1) shows at least one through opening (4) which in parallel to the wafer surface has a square cross-section, and whose walls form with the wafer surface an angle of approximately 54.7°, and that the metal silicide layer (6) covers the lower and the upper surface of the silicon wafer, and the walls of the opening (4) of openings (4), respectively.

6. Structure as claimed in one of claims 1 to 4, characterized in that the silicon body (10) consists of a thin layer (11) and of a supporting structure (12) supporting the layer (11) regionwise and being doped differently from the layer (11), and that in those areas where it is not supported by the supporting structure (12) the layer (11) shows one through opening (18), or through openings (18), respectively.

7. Structure as claimed in claim 6, characterized in that the layer (11) is P$^+$-doped, and the supporting structure (12) is of low doping, or no doping at all, that at least one tub-shaped recess (13) extends into the silicon body (10), the side walls of said recess being formed by the supporting structure (12) and form with the layer (11) and angle of 54.7°, and the floor of said recess being formed by the layer (11), and that the metal silicide layer (20) covers that surface of the layer (11) which faces away from the supporting structure (12), and possibly also the walls of the opening (18) or openings (18), respectively.

8. Structure as claimed in claim 7, characterized in that the silicon body is covered on one side with a layer (15) transparent for X-rays, e.g. silicon dioxide which also covers on one side the opening (18) or openings (18), respectively, and that there is possibly on the layer (15) a further layer (16) — equally transparent to X-rays —, e.g. of silicon nitride.

9. Method of making a structure as claimed in any one of claims 1 to 8, wherein on the shallow silicon body (21, 30) having through openings (25, 39) a thin layer (27, 40) is applied at least on one side, characterized in that the thin layer (27, 40) is generated out of the metal determined for silicide formation, or out of a mixture containing the metal and silicon in a correct ratio for silicide formation, and there follows an annealing step until the complete transformation of the metal on the silicon into the silicide.

10. Method as claimed in claim 9, characterized in that in order to make the through openings (25, 39) the silicon body (21, 30), starting from the one surface, is selectively etched through either completely, or thinned to such an extent that there only remains a thin layer in the etched areas, and that subsequently through openings (39) are etched into the thinned areas.

11. Method as claimed in claim 9 or 10, characterized in that prior to the making of the through openings (25, 39) at least one layer (22, 36) consisting e.g. of silicon dioxide is applied on that surface of the silicon body (21, 29) to which etching is taking place.

12. Method as claimed in any one of claims 9 or 10, characterized in that onto a silicon body (21) polished on both sides and of (100)-orientation a silicon dioxide layer (22 or 23, respectively) is thermally grown on both sides, that prior to the complete through-etching of the silicon body (21) circular holes (24) are etched, in accordance with a predetermined pattern, into the silicon dioxide layer (23) by means of reactive ion etching, that through-etching is effected anisotropically, and using the etched silicon dioxide layer (23) as etching mask, that the silicon dioxide layers (22 and 23) are etched off, and that prior to annealing to produce the silicide the silicon body (21) is coated with a thin metallic layer (27) through two-side vapor deposition.

13. Method as claimed in any one of claims 9 or 10, characterized in that a silicon body (30) of (100)-orientation polished on both sides and at most of a low doping is boron-doped on one side so that a silicon layer (31) is obtained approximately 1.5 to approximately 3 μm thick whose doping everywhere $\geq 7 \times 10^{19}$ boron atoms/cm³, that on the surface of the silicon body (30) facing away from the silicon layer (31) a silicon dioxide layer (32) containing at least one opening (33) is made, that during thin etching, using the silicon dioxide layer (32) as an etching mask the still existing silicon of at most low doping is etched off anisotropically down to the silicon layer (31), with a supporting structure out of low-doping areas of the silicon wafer (30) being formed, that the etching mask (32) is removed, that on the surface of the silicon layer (31) facing away from the supporting structure a thin silicon dioxide layer (35) is grown, and on the supporting structure, and on the exposed surface of the silicon layer (31) another thin layer (36) is grown of a material, e.g. SiO₂, transparent to X-rays, and in whose presence Si can be etched by means of reactive ion etching and which does not form a silicide with metal, and that thereon a layer (37) is grown of a material, e.g. Si₃N₄ transparent to X-rays, and which with the underlaying layer beneath provides a mask substrate that is stable also under thermal stress, that by means of reactive ion etching in the silicon dioxide layer (35) a pattern of through holes (38) corresponding to the desired pattern of through openings is provided, that by means of reactive ion etching in an atmosphere containing argon and chlorine, and by using the pattern of through holes (38) through openings (39) are made in the silicon layer (31) remaining after thin etching, etching being stopped after the layer bordering on the layer (36) has been etched through, that after the removal of the silicon dioxide layer (35) and prior to the annealing, the silicide forming metal, as e.g. tungsten, is vapor deposited in a thin layer (40 or 41, respectively), on the exposed surface of the silicon layer (31) and of the surface of the layer (36) exposed in the openings (39), and that finally the non-converted metal on the layer (36) is etched off.

## Revendications

1. Structure qui comprend un corps de silicium monocristallin plat (1, 10) présentant au moins une ouverture (4, 18) le traversant de part en part et qui comporte une mince couche (6, 20) recouvrant et liant le corps de silicium (1, 10) au moins d'un côté, caractérisée par le fait que la couche mince (6, 20) est constituée par le siliciure d'un métal lourd et que le siliciure métallique est combiné au silicium par liaison chimique.

2. Structure selon la revendication 1, caractérisée par le fait que comme composant métallique du siliciure, on utilise un métal qui a un numéro atomique élevé et dont le siliciure a une densité élevée.

3. Structure selon la revendication 2, caractérisée par le fait que le métal est sélectionné parmi le groupe tungstène, molybdène, tantale, rhénium, niobium, iridium, platine et palladium.

4. Structure selon l'une des revendications 1 à 3, caractérisée par le fait que le corps de silicium (1, 10) est constitué par une plaquette de silicium monocristallin à orientation (100).

5. Structure selon la revendication 4, caractérisée par le fait que le corps de silicium (1) comporte au moins une ouverture (4) le traversant de part en part laquelle, parallèlement à la surface de la plaquette, présente une section transversale carrée et dont les parois forment avec la surface de la plaquette un angle d'environ 54,7°, et que la couche de siliciure métallique (6) recouvre la surface inférieure et la surface supérieure de la plaquette de silicium et les parois de l'ouverture (4) ou des ouvertures (4).

6. Structure selon l'une des revendications 1 à 4, caractérisée par le fait que le corps de silicium (10) est constitué par une mince couche (11) et par une structure d'appui (12) qui soutient par zones la couche (11) et est dopée autrement que la couche (11) et que la couche 1(1) dans les zones où elle n'est pas soutenue par la structure d'appui (12) comporte une ouverture (18) ou des ouvertures (18) la traversant de part en part.

7. Structure selon la revendication 6, caractérisée par le fait que la couche (11) est dopée P$^+$ et la structure d'appui (12) n'est pas ou que peu dopée, que dans le corps de silicium (10) s'étend au moins un creux (13) en forme de cuvette dont les parois latérales sont formées par la structure d'appui (12) et forment avec la couche (11) un angle de 54,7° et dont le fond est formé par la couche (11) et que la couche de siliciure métallique (20) recouvre la surface, opposée à la structure d'appui (12), de la couche (11), et éventuellement aussi les parois de l'ouverture (18) ou des ouvertures (18).

8. Structure selon la revendication 7, caractérisée par le fait que le corps de silicium est recouvert d'un côté par une couche (15) transparente aux rayons X, par exemple en dioxyde de silicium, qui ferme aussi d'un côté l'ouverture (18) ou les ouvertures (18) et que dans certaines conditions sur la couche (15) est encore appliquée une couche (16) également transparente aux rayons X, par exemple en nitrure de silicium.

9. Procédé pour la fabrication d'une structure selon l'une des revendications 1 à 8, dans lequel sur le corps de silicium plat (21, 30) muni d'ouvertures (25, 39) le traversant de part en part, on applique au moins d'un côté une mince couche (27, 40) caractérisé par le fait que la mince couche (27, 40) est formée à partir du métal destiné à la formation du siliciure ou à partir d'un mélange contenant le métal et du silicium dans le rapport exact pour la formation du siliciure et qu'elle est ensuite recuite jusqu'à la transformation complète en siliciure du métal appliqué sur le silicium.

10. Procédé selon la revendication 9, caractérisé par le fait que pour la réalisation des ouvertures traversantes (25, 39), à partir de l'une des surfaces soit on perfore sélectivement le corps de silicium (21, 30) complètement, soit l'amincit tout d'abord suffisamment pour que dans les zones attaquées il ne subsiste encore qu'une mince couche, et qu'on perce ensuite les ouvertures traversantes (39) dans les zones amincies.

11. Procédé selon la revendication 9 ou 10, caractérisé par le fait qu'avant de réaliser les ouvertures traversantes (25, 39) sur la surface du corps du cilicium (21, 29) jusqu'à laquelle est effectué le perçage, on applique au moins une couche (22, 36) qui est par exemple constituée par du dioxyde de silicium.

12. Procédé selon l'une des revendications 9 ou 10, caractérisé par le fait que sur un corps de silicium (21) à orientation (100) poli des deux côtés on dépose thermiquement par épitaxie sur ses deux faces une couche de dioxyde de silicium (22 et 23), qu'avant la perforation complète du corps de silicium (21) on perce des trous circulaires (24) dans la couche de dioxyde de silicium (23) par attaque ionique réactive et suivant un dessin préétabli, qu'on effectue la perforation en utilisant la couche de dioxyde de silicium percée (23) comme masque et de façon isotrope, qu'on enlève les couches de dioxyde de silicium (22 et 23) et, qu'avant le recuit pour produire le siliciure, on entoure le corps du silicium (21) d'une mince couche métallique 27 déposée sur ses deux faces par évaporation sous vide.

13. Procédé selon l'une des revendications 9 ou 10, caractérisé par le fait que, sur une face, on dope au bore un corps de silicium (30) poli des deux côtés, tout au plus faiblement dopé et à orientation (100) de façon à obtenir une couche de silicium (31) d'environ 1,5 à environ 3 μm d'épaisseur dont le dopage est partant supérieur ou égal à $7 \times 10^{19}$ atomes de bore/cm$^3$, que sur la surface, opposée à la couche de silicium (31), du corps de silicium (30), on forme une couche de dioxyde de silicium (32) comportant au moins une ouverture (33), que par un amincissement avec utilisation de la couche de dioxyde de silicium (32) comme masque, on enlève de façon anisotrope le silicium, encore présent et tout au plus faiblement dopé, jusqu'à la couche de silicium (31), une structure d'appui étant formée par les zones faiblement dopées de la plaquette de silicium (30), que l'on enlève le masque (32), que sur la surface, opposée à la structure d'appui, de la couche de silicium (31) on dépose par épitaxie une mince couche de dioxyde de silicium (35) et, sur la structure d'appui et sur la surface mise à nu de la couche de silicium (31), également une mince couche (36) d'un matériau, par exemple du SiO$_2$, qui est transparent aux rayons X et en présence duquel du Si peut être attaqué par attaque ionique réactive et qui ne forme aucun siliciure avec le métal et, par dessus, une couche (37) en un matériau, par exemple en Si$_3$N$_4$, qui est transparent aux rayons X et forme avec là couche sous-jacente un support de masque stable, même en cas de contrainte thermique, que par attaque ionique réactive on réalise dans le couche de dioxyde de silicium (35) un dessin de trous traversants (38) correspondant au dessin souhaité des ouvertures traversantes, que par attaque ionique réactive dans une atmosphère contenant de l'argon et du chlore et en utilisant le dessin de trous traversants (38) on réalise les ouvertures traversantes (39) dans la couche de silicium (31) subsistant après amincissement, l'attaque cessant après la perforation de la couche limite jusqu'à la couche (36), qu'après enlèvement de la couche de dioxyde de silicium (35) et avant le recuit, on évapore sous vide le métal capable de former le siliciure, comme par exemple du tungstène, et on le dépose en couches minces (40 et 41) sur la surface mise à nu de la couche de silicium (31) et sur la surface, mise à nu dans les ouvertures, de la couche (36) et que pour finir on enlève le métal non transformé sur la couche (36).

FIG. 1

FIG. 2

FIG. 3

FIG.4A

FIG.4B

FIG.4C

FIG.4D

FIG.4E

FIG.4F

FIG.4G

FIG. 5A

FIG. 5B

FIG. 5C

FIG. 5D

FIG. 5E

FIG. 5F

FIG. 5G